# EUROPÄISCHE PATENTSCHRIFT

(11) **EP 3 583 246 B1**
(45) Veröffentlichungstag und Bekanntmachung des Hinweises auf die Patenterteilung: **24.06.2020**
(21) Anmeldenummer: 18703285.9
(22) Anmeldetag: 31.01.2018
(51) Int. Cl.: C30B 13/20, C30B 13/28, C30B 13/30, C30B 29/06

(54) **VERFAHREN ZUM ZIEHEN EINES EINKRISTALLS NACH DEM FZ-VERFAHREN**
METHOD FOR PULLING A MONOCRYSTAL IN ACCORDANCE WITH THE FZ METHOD
PROCÉDÉ DE TIRAGE D'UN MONOCRISTAL SELON LE PROCÉDÉ DE LA ZONE FLOTTANTE

(30) Priorität: 14.02.2017 DE 102017202311
(43) Veröffentlichungstag der Anmeldung: 25.12.2019
(73) Patentinhaber: Siltronic AG, 81737 München (DE)
(72) Erfinder: SCHRÖCK, Thomas, 84556 Kastl (DE)
(74) Vertreter: Staudacher, Wolfgang
(86) Internationale Anmeldenummer: PCT/EP2018/052352
(87) Internationale Veröffentlichungsnummer: WO 2018/149640

(56) Entgegenhaltungen:
- WO-A1-2014/033212
- JP-A- H11 189 486
- JP-A- 2000 044 380
- JP-A- 2016 023 099

## Beschreibung

Die vorliegende Erfindung betrifft ein Verfahren zum Ziehen eines Einkristalls nach dem FZ-Verfahren, bei dem ein Polykristall mittels einer elektromagnetischen Schmelzvorrichtung aufgeschmolzen und anschließend wieder auskristallisiert wird, sowie eine entsprechende Anlage.

### Stand der Technik

Beim Ziehen von Einkristallen, insbesondere aus Halbleitermaterial, nach dem FZ-Verfahren, dem sogenannten Floating-Zone-Verfahren bzw. Zonenziehverfahren, können sehr reine Einkristalle erzeugt werden. Hierbei wird ein Polykristall, also insbesondere ein Kristall aus polykristallinem Halbleitermaterial, aufgeschmolzen und anschließend wieder auskristallisiert.

Bei einem solchen Verfahren können verschiedene Phasen unterschieden werden, wie sie beispielsweise in WO 2014/033212 A1 beschrieben werden. Der Polykristall wird hierbei zunächst aufgeschmolzen und dann an einem einkristallinen Impfling wieder auskristallisiert.

Dabei wird der Durchmesser des zu fertigenden Einkristalls von zunächst in etwa dem Durchmesser des Impflings in einem sog. Dünnhals-Abschnitt verkleinert und anschließend in einem konischen Abschnitt bis zu einem gewünschten Durchmesser geweitet. Dann kann der Durchmesser konstant gehalten werden, um beispielsweise einen stabförmigen Einkristall zu erhalten.

Aus der JP 4 016 363 B2 ist beispielsweise ein FZ-Verfahren bekannt, bei dem unter Verwendung vier verschiedener Kameras verschiedene Bereiche des Polykristalls, des daran angebrachten Impflings sowie des dazwischen befindlichen flüssigen bzw. geschmolzenen Materials aufgenommen werden. Daraus wird dann neben Durchmessern des Polykristalls bzw. des Einkristalls eine Höhe des Bereichs bzw. der Zone des flüssigen bzw. geschmolzenen Materials, die sog. Zonenhöhe, ermittelt. Basierend auf dieser Höhe wird dann eine Leistung für die Induktionsspule, mittels welcher der Polykristall aufgeschmolzen wird, dynamisch angepasst, um so insbesondere den erwähnten Dünnhals-Abschnitt zu bilden. Ebenso können eine Absenkgeschwindigkeit des Impflings und/oder des Polykristalls eingestellt oder angepasst werden.

Nachteilig an dem erwähnten Vorgehen sind jedoch die vielen benötigten Kameras, um die Bereiche zu erfassen, basierend auf welchen dann die Zonenhöhe ermittelt wird.

Weitere FZ-Verfahren mit Überwachung der Schmelzzone und darauf basierender Heizleistungsregelung sind in JPH11189486 und JP2016023099 offenbart.

Vor diesem Hintergrund stellt sich daher die Aufgabe, eine einfachere und genauere Möglichkeit zur Anpassung der Leistung der Schmelzvorrichtung zur Verfügung zu stellen, um so insbesondere eine Automatisierung des Prozesses zu ermöglichen.

### Offenbarung der Erfindung

Erfindungsgemäß wird ein Verfahren zum Ziehen eines Einkristalls mit den Merkmalen des unabhängigen Patentanspruchs 1 vorgeschlagen.

Vorteilhafte Ausgestaltungen sind Gegenstand der Unteransprüche sowie der nachfolgenden Beschreibung.

Die Erfindung geht aus von einem Verfahren zum Ziehen eines Einkristalls nach dem FZ-Verfahren, bei dem ein Polykristall mittels einer elektromagnetischen Schmelzvorrichtung aufgeschmolzen und anschließend wieder auskristallisiert wird. Als Material für den Polykristall und damit auch den zu fertigenden Einkristall kommt hier insbesondere ein Halbleitermaterial, bevorzugt Silizium, in Frage. Es versteht sich, dass das Material auch gewisse Unreinheiten oder Dotierungen enthalten kann.

In einer ersten Phase wird der Polykristall, der in aller Regel stabförmig mit einem Durchmesser von beispielsweise 160 mm ausgebildet ist, zunächst mittels einer Schmelzvorrichtung, beginnend an einem (in Bezug zur Schwerkraft bei vertikaler Anordnung des stabförmigen Polykristalls) unteren Ende, aufgeschmolzen. Als Schmelzvorrichtung kommt hier insbesondere ein Induktor bzw. eine Induktionsspule in Betracht. Hierbei kann durch Anregung mittels Hochfrequenz elektromagnetische Energie in den Polykristall, der in die Nähe des Induktors gebracht wird, eingekoppelt werden.

In der erwähnten ersten Phase kann der Polykristall, der an seinem unteren Ende in aller Regel konisch ausgebildet ist, ggf. mit einem flachen unteren Abschnitt, abgesenkt und an ein mittiges Loch im Induktor herangeführt werden. Um möglichst viel elektromagnetische Energie in den Polykristall einzukoppeln, ist es zweckmäßig, das untere Ende des Polykristalls an den Rand des Lochs zu bringen. Der Polykristall beginnt dann am unteren Ende zu schmelzen, wobei sich zunächst ein Tropfen flüssigen Materials bildet, der am Polykristall hängt.

In einer zweiten Phase wird nun ein einkristalliner Impfling, der insbesondere ebenfalls stabförmig ausgebildet ist und einen Durchmesser von beispielsweise ca. 4 bis 7 mm aufweist, an das untere Ende des Polykristalls und damit an den Tropfen flüssigen Materials, angebracht und dann vorzugsweise beginnend von einem oberen Ende des Impflings an aufgeschmolzen. Das Aufschmelzen des Impflings beginnt dabei in der Regel erst, nachdem sich die Temperatur des Impflings an diejenige des bereits flüssigen Materials angeglichen hat. Der Impfling kann zweckmäßigerweise über einen gewissen Bereich seiner Länge, die beispielsweise zwischen 5 und 20 mm liegen kann, aufgeschmolzen werden. Es versteht sich jedoch, dass ein gewisser Bereich an seinem unteren Ende nicht aufgeschmolzen wird, da dieser Abschnitt wenigstens zum Teil zur Befestigung in einer Ziehvorrichtung benötigt wird. Zum Aufschmelzen des Impflings werden der Impfling und der Polykristall nach oben bewegt. Dies bedeutet beispielsweise, dass der Impfling in Richtung des Lochs des Induktors bewegt wird. Dabei wird ein Vorimpfling an dem unteren Ende des Polykristalls gebildet. Unter einem Vorimpfling ist dabei ein Bereich, insbesondere in Form eines Zapfens, am unteren Ende des Polykristalls zu verstehen, an dem dann der Impfling angebracht ist.

In einer dritten Phase wird nun zwischen einem unteren Abschnitt des Impflings (an dem dieser beispielsweise in der erwähnten Ziehvorrichtung gehalten werden kann) und dem Polykristall (also dem noch festen und noch nicht geschmolzenen Anteil des Polykristalls) ein Dünnhals-Abschnitt gebildet, dessen Durchmesser geringer als derjenige des Impflings ist. Dieser Dünnhals-Abschnitt wird gebildet, um etwaige Versetzungen, die sich beispielsweise durch das Anbringen des Impflings an das flüssige Material am Polykristall, bilden, zu entfernen. Der Durchmesser des Dünnhals-Abschnitts kann dabei beispielsweise zwischen 2 und 4 mm betragen. Zur Ausbildung dieses Dünnhals-Abschnitts können der Impfling und der Polykristall, nachdem der Impfling wie gewünscht aufgeschmolzen ist, wieder nach unten bewegt werden. Indem nun die Absenkgeschwindigkeit des Impflings erhöht wird, nimmt der Durchmesser der Zone flüssigen Materials bzw. des dann auskristallisierenden Materials aufgrund der Massenerhaltung ab.

Nach dem Dünnhals-Abschnitt kann dann der Durchmesser des Einkristalls bis zu einem gewünschten Durchmesser von beispielsweise ca. 200 mm erhöht und dann beibehalten werden. Auf diese Phasen soll später noch detaillierter eingegangen werden.

Bei der Ausbildung des Dünnhals-Abschnitts, also während der dritten Phase, ergibt sich nun das Problem, dass elektromagnetische Energie, die mittels der Schmelzvorrichtung in das feste Material eingekoppelt werden soll, unterhalb einer Materiastärke von ca. 4 mm nur noch schwierig in das Material einkoppelt. Der Grund hierfür liegt darin, dass die freie Weglänge für den induzierten Strom zu kurz wird. Dies wiederum führt zu einer schnelleren Kristallisation und zu einer damit verbundenen Änderung der Höhe bzw. des Abstands der unteren Phasengrenze vom Induktor, dadurch zu einer Änderung des Durchmessers und somit erneut zu einer Änderung der eingekoppelten Energie. Mit anderen Worten, der Abstand der unteren Phasengrenze vom Induktor beginnt dazu zu neigen, in unkontrollierter Weise zu oszillieren. Daneben hängt die Menge der eingekoppelten Energie bzw. Leistung in der Regel auch von weiteren Parametern wie dem initialen Abmessungen des Impflings und des Polykristalls sowie den Abmessungen und der Ausrichtung der Schmelzvorrichtung bzw. des Induktors ab. Bei Vorgabe eines bestimmten Werts oder eines bestimmten Verlaufs für die Leistung der Schmelzvorrichtung ist eine gezielte Ausbildung eines gewünschten Dünnhals-Abschnitts in dieser Situation also kaum möglich. Die Gesamthöhe zwischen den beiden Phasengrenzen, wie dies in den eingangs erwähnten Verfahren der Fall ist, ist damit keine Größe, anhand welcher eine gute Regelung vorgenommen werden kann.

Erfindungsgemäß wird nun die Leistung der Schmelzvorrichtung vor der dritten Phase, und insbesondere während der zweiten Phase, wenigstens zeitweise in Abhängigkeit von einer Position der unteren Phasengrenze zwischen flüssigem Material und festem Material auf Seiten des Impflings dynamisch angepasst, d.h. die Leistung wird beispielsweise in Abhängigkeit von der Position über die Zeit hinweg geeignet geändert oder geregelt. Zusätzlich wird während der dritten Phase die Leistung der Schmelzvorrichtung dann wenigstens zeitweise in Abhängigkeit von einer Position der oberen Phasengrenze zwischen flüssigem Material und festem Material auf Seiten des Polykristalls dynamisch angepasst.

Zweckmäßig ist es dabei, die jeweilige Position oder eine damit in Zusammenhang stehende Größe als Regelgröße und die Leistung der Schmelzvorrichtung entsprechend als Stellgröße zu verwenden. Als mit der jeweiligen Position in Zusammenhang stehende Größe kommt bevorzugt ein Abstand der jeweiligen Phasengrenze zu einem fixen Bezugspunkt, der sich insbesondere an der Schmelzvorrichtung befindet, in Frage. Da die Phasengrenze in Umlaufrichtung in der Regel nicht gerade verläuft, kommt hier insbesondere eine Mittelung über beispielsweise einen erfassbaren Bereich in Frage. Die Bezugspunkte können dabei verschieden oder identisch sein. Dies ermöglicht eine einfache Erfassung der Position der jeweiligen Phasengrenze, insbesondere wenn der gesamte Prozess mittels einer oder mehrerer Kameras aufgenommen wird. Zweckmäßig sind hier eine Kamera, die insbesondere unterhalb der Schmelzvorrichtung angeordnet ist, für die untere Phasengrenze und eine Kamera, die insbesondere oberhalb der Schmelzvorrichtung angeordnet ist, für die obere Phasengrenze. Die von den Kameras erfassten Bilder können dann entsprechend (automatisiert) ausgewertet werden, um die nötigen Positionen bzw. Abstände zu erhalten.

Während des Abschmelzens des Impflings in der zweiten Phase ist der Durchmesser des Materials hinreichend groß, sodass elektromagnetische Energie gut einkoppelt und so die Position der genannten unteren Phasengrenze als guter Anhaltspunkt zur Ermittlung der Leistung der Schmelzvorrichtung verwendet werden kann. Bei einer bestimmten Geschwindigkeit, mit welcher der Impfling (und der Polykristall) verfahren (beim Aufschmelzen des Impflings insbesondere angehoben) werden, kann die Leistung der Schmelzvorrichtung also beispielsweise dynamisch so angepasst werden, dass die Position der unteren Phasengrenze bzw. deren Abstand zu einem Bezugspunkt möglichst konstant bleibt oder einer Sollkurve folgt.

Während der Ausbildung des Dünnhals-Abschnitts hingegen ist die Position der genannten unteren Phasengrenze kein guter Anhaltspunkt zur Ermittlung der Leistung der Schmelzvorrichtung mehr, da - wie erwähnt - die elektromagnetische Energie bei geringem Durchmesser nur schlecht in das Material einkoppelt, wodurch sich auch die Kristallisationsrate stark ändert und damit die Position der untere Phasengrenze sehr stark schwankt. Dieser Effekt würde sich umso mehr erhöhen, je länger die Position der unteren Phasengrenze zur Anpassung der Leistung der Schmelzvorrichtung verwendet würde.

Die Position der genannten oberen Phasengrenze hingegen dient bei der Ausbildung des Dünnhals-Abschnitts als guter Anhaltspunkt zur Ermittlung der Leistung der Schmelzvorrichtung, da dort, also am unteren Ende des festen Polykristalls, der Durchmesser des Materials hinreichend groß ist, sodass elektromagnetische Energie gut einkoppelt. Die Phasengrenze ändert sich dort also nicht unkontrolliert.

Auf diese Weise ist somit eine dynamische Anpassung der Leistung der Schmelzvorrichtung sowohl während des Aufschmelzens des Impflings als auch zur Ausbildung des Dünnhals-Abschnitts möglich. Zur ununterbrochenen, genauen Einstellung bzw. Anpassung der Leistung wird ein Wechsel der Abhängigkeit von der Position der unteren Phasengrenze unmittelbar zu der Abhängigkeit von der Position der oberen Phasengrenze vorgenommen. Als Zeitpunkt dieses Wechsels kommt insbesondere ein Zeitpunkt vor einer Erhöhung einer Geschwindigkeit, mit welcher der Impfling und/oder der Polykristall in vertikaler Richtung bewegt werden, in Frage. Alternativ, jedoch nicht Gegenstand der Erfindung, ist auch ein gewisser zeitlicher Überlapp der Verwendung der beiden Größen denkbar, um den Übergang stabil zu halten. Wenn nach dem Aufschmelzen des Impflings der Dünnhals-Abschnitt gebildet werden soll, ist zunächst eine Umkehrung der Bewegungsrichtung von Impfling und Polykristall nötig, d.h. beide müssen abgesenkt werden. Zur Ausbildung des Dünnhals-Abschnitts ist dann weiterhin - wie bereits erwähnt - eine Erhöhung der Geschwindigkeit, insbesondere der Absenkgeschwindigkeit, nötig, um den Durchmesser zu reduzieren. Wenn nun vor dieser Erhöhung der Geschwindigkeit, insbesondere auch unmittelbar zuvor, der Wechsel der Position, in Abhängigkeit von welcher die Leistung angepasst wird, vorgenommen wird, besteht keine Gefahr, dass die Leistung aufgrund der schlechten Einkopplung der elektromagnetischen Energie falsch angepasst wird.

In einer vierten Phase beim FZ-Verfahren kann nun zwischen dem Dünnhals-Abschnitt und dem Polykristall ein konischer Abschnitt gebildet werden. Ein solcher konischer Abschnitt dient dazu, den Durchmesser von demjenigen des Dünnhals-Abschnitts auf einen gewünschten Durchmesser zu weiten. Vorzugsweise wird die Leistung der Schmelzvorrichtung nun während der vierten Phase wenigstens zeitweise in Abhängigkeit von einer charakteristischen Größe, mit der auf einen Neigungswinkel des konischen Abschnitts oder dessen Änderung geschlossen werden kann, dynamisch angepasst. Als solche charakteristische Größe kommen insbesondere der Neigungswinkel des konischen Abschnitts von kristallisiertem Material, ein Neigungswinkel des konischen Abschnitts an einem Tripelpunkt zwischen festem Material, flüssigem Material und Umgebung, eine Änderung eines Durchmessers des konischen Abschnitts oder der Durchmesser des konischen Abschnitts an der unteren Phasengrenze (die sich dann bereits zwischen dem konischen Abschnitt des Einkristalls und dem flüssigen Material befindet) in Betracht, wobei bei letzterem ggf. eine Anpassung einer verwendeten Reglerstruktur nötig sein kann. Mittels jeder dieser Größen als Grundlage für die Anpassung der Leistung kann eine gewünschte Form des Konus, also insbesondere ein gewünschter Neigungswinkel erreicht werden. Es versteht sich, dass auch eine Absenkgeschwindigkeit des Impflings (zusammen mit dem bereits daran auskristallisierten Material) und des Polykristalls verändert werden muss, um den Durchmesser zu erhöhen. Insbesondere führt eine Verringerung der Absenkgeschwindigkeit dazu, dass mehr Material auskristallisieren kann, wodurch der Durchmesser erhöht wird.

Wie bereits beim Wechsel von der Position der unteren Phasengrenze zu derjenigen der oberen Phasengrenze, ist es auch hier von Vorteil, einen Wechsel der Abhängigkeit von der Position der oberen Phasengrenze unmittelbar zu der Abhängigkeit von der charakteristischen Größe vorzunehmen. Auf diese Weise ist eine ununterbrochene Anpassung der Leistung möglich. Denkbar ist jedoch auch hier wieder ein gewisser zeitlicher Überlapp, währenddessen die Leistung in Abhängigkeit von der Position der oberen Phasengrenze und in Abhängigkeit der charakteristischen Größe angepasst wird.

Als Zeitpunkt dieses Wechsels kommt insbesondere ein Zeitpunkt in Betracht, zu dem eine Erkennung der Position der oberen Phasengrenze nur noch mit weniger als einer vorbestimmten Genauigkeit möglich ist. Bei der Ausbildung des konischen Abschnitts muss aufgrund des zunehmenden Durchmessers des Polykristalls, der aufgeschmolzen wird, immer mehr Material vom Polykristall aufgeschmolzen werden. Die obere Phasengrenze, also die Grenze zwischen festem und flüssigem Silizium, wird dabei weniger scharf und ist somit irgendwann nicht mehr hinreichend genau bestimmbar, um basierend darauf die Leistung der Schmelzvorrichtung anzupassen.

Zweckmäßig ist es auch hier, wenn zur Ermittlung der charakteristischen Größe eine Kamera, die insbesondere unterhalb der Schmelzvorrichtung angeordnet ist, verwendet wird. Insbesondere kann hierfür auch diejenige Kamera verwendet werden, die bereits für die Erfassung der unteren Phasengrenze verwendet wird. Die von der Kamera erfassten Bilder können dann entsprechend (automatisiert) ausgewertet werden, um die nötige Größe zu erhalten.

Offenbart wird weiterhin eine Anlage, die zur Durchführung des erfindungsgemäßen Verfahrens eingerichtet ist. Die Anlage kann hierzu insbesondere eine Schmelzvorrichtung, wie sie beispielsweise bereits mehrfach erwähnt wurde, sowie auch eine geeignete Recheneinheit aufweisen. Die Recheneinheit kann dann entsprechen eingerichtet sein, die einzelnen Verfahrensschritte durchzuführen und beispielsweise auch, die Kameras entsprechend anzusteuern und deren Bilder auszuwerten.

Zur Vermeidung von Wiederholungen sei im Übrigen hinsichtlich weiterer Ausgestaltungen sowie der Vorteile der Anlage auf obige Erläuterungen zum erfindungsgemäßen Verfahren verwiesen.

Weitere Vorteile und Ausgestaltungen der Erfindung ergeben sich aus der Beschreibung und der beiliegenden Zeichnung.

Die Erfindung ist anhand eines Ausführungsbeispiels in der Zeichnung schematisch dargestellt und wird im Folgenden unter Bezugnahme auf die Zeichnung beschrieben.

### Figurenbeschreibung

Figur 1 zeigt schematisch einen Polykristall und eine Schmelzvorrichtung, womit ein erfindungsgemäßes Verfahren durchführbar ist.
Figur 2 zeigt die Schmelzvorrichtung aus Figur 1 in einer anderen Ansicht.
Figuren 3a bis 3d zeigen schematisch verschiedene Phasen eines erfindungsgemäßen Verfahrens in einer bevorzugten Ausführungsform.
Figur 4 zeigt einen zeitlichen Ablauf eines erfindungsgemäßen Verfahrens in einer bevorzugten Ausführungsform.
Figur 5 zeigt ein Diagramm zur Einkopplung elektromagnetischer Energie in Halbleitermaterial.

### Ausführungsform der Erfindung

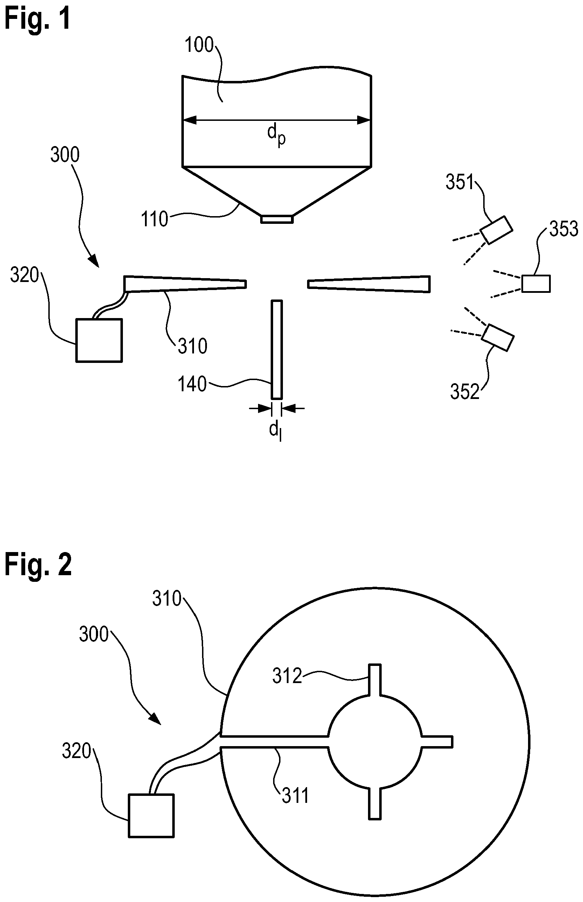

In Figur 1 sind schematisch einen Polykristall 100 und eine Schmelzvorrichtung 300, womit ein erfindungsgemäßes Verfahren durchführbar ist, in Seitenansicht dargestellt. Die Schmelzvorrichtung 300 weist hier einen Induktor bzw. eine Induktionsspule 310 auf, die mittels einer Ansteuereinheit 320, die über entsprechende Leitungen angeschlossen ist, beispielsweise mit Hochfrequenz entsprechend angesteuert bzw. betrieben werden kann.

Die Schmelzvorrichtung 300 kann dabei Teil einer Anlage, die zum Ziehen eines Einkristalls eingerichtet ist, sein. Eine solche Anlage kann dann zudem entsprechende Halteeinrichtungen für den Induktor 300, den Einkristall 100 sowie die Kameras 351, 352 und 353 aufweisen. Weiterhin kann eine solche Anlage eine Recheneinheit (nicht dargestellt) zum Steuern der übrigen Bestandteile aufweisen.

Der Polykristall 100, der insbesondere Silizium aufweisen oder aus diesem bestehen kann, ist überwiegend stabförmig oder zylinderförmig. Im stab- bzw. zylinderförmigen Bereich, von dem hier nur ein Teil dargestellt ist, hat der Polykristall 100 einen Durchmesser dp, der beispielsweise 160 mm betragen kann. An seinem unteren Ende ist der Polykristall 100 jedoch konisch ausgebildet, d.h. erweist einen konischen Abschnitt 110 auf. Weiterhin ist zu sehen, dass der konische Abschnitt 110 wiederum ein flaches Ende an seinem unteren Ende aufweisen kann.

Sofern der Polykristall nicht mechanisch bearbeitet wurde, sondern beispielsweise aus einem - nicht zu Ende geführten - Schmelzvorgang stammt, kann dieses untere Ende auch anders ausgebildet sein. Weiterhin ist ein Impfling 140 mit einem Durchmesser d_{I}, der beispielsweise 4 bis 7 mm betragen kann, zu sehen. Bei dem Impfling handelt es sich um einen Einkristall, der ebenfalls stab- bzw. zylinderförmig ausgebildet sein kann.

In Figur 2 ist die Schmelzvorrichtung 300 aus Figur 1 in einer anderen Ansicht, hier einer Draufsicht, dargestellt, allerdings ohne den Polykristall 100. Hier ist nun deutlich eine Ausnehmung bzw. ein Loch in der Mitte des Induktors 310 zu sehen, durch welches der Polykristall - während des Schmelzvorgangs und dann in verflüssigtem Zustand - hindurch geführt wird.

Insbesondere sind hier nun ein Hauptschlitz 311 sowie drei Nebenschlitze 312 zu sehen, die für die Funktion der Schmelzvorrichtung, insbesondere zu Erzeugung der elektromagnetischen Energie, nötig ist. Wie zu sehen ist, ist der Induktor aufgrund des Hauptschlitzes 311 nicht geschlossen.

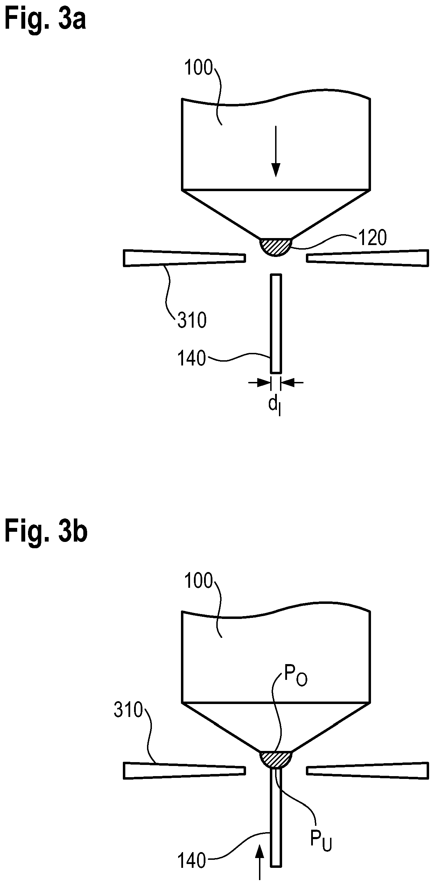

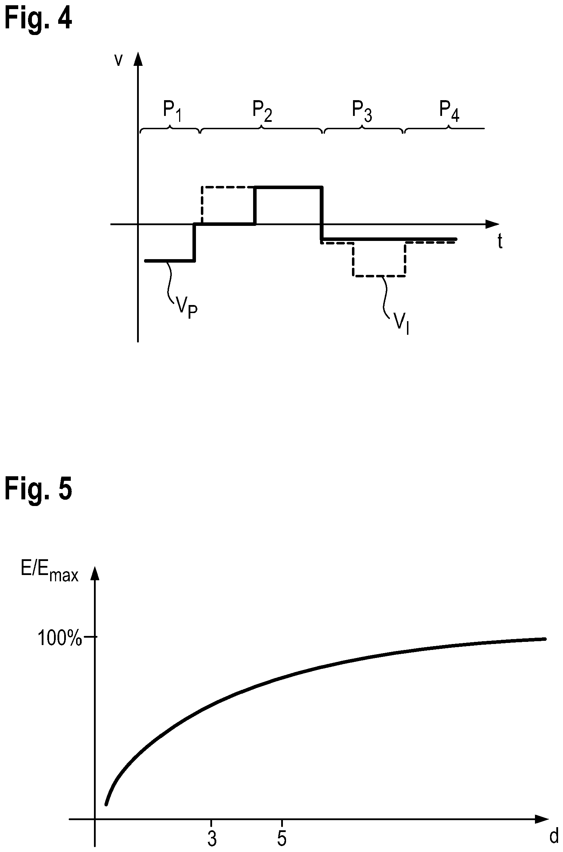

In den Figuren 3a bis 3f sind nun schematisch verschiedene Phasen eines erfindungsgemäßen Verfahrens in einer bevorzugten Ausführungsform dargestellt. Der Ablauf des Verfahrens soll im Folgenden anhand der Figuren 3a bis 3f sowie der Figur 4, die die Geschwindigkeiten v_{P} des Polykristalls und v_{I} des Impflings in den einzelnen Phasen über der Zeit t zeigt, näher erläutert werden.

In einer ersten Phase P₁ wird der Polykristall 100 zunächst an den Induktor 310 bzw. die Ausnehmung in dessen Mitte herangeführt. Hierzu wird der Polykristall beispielsweise mit einer konstanten Geschwindigkeit abgesenkt. Der Impfling 140 muss hierbei noch nicht bewegt werden. Entgegen der hier gezeigten Ausrichtung kann der Polykristall 100 auch näher an einen inneren Rand des Induktors 310 herangeführt werden, um eine bessere Einkopplung der elektromagnetischen Energie in den Polykristall 100 zu ermöglichen.

Der Polykristall 100 beginnt damit an seinem unteren Ende, also auch dem unteren Ende des konischen Abschnitts, aufzuschmelzen. Hierbei bildet sich ein Tropfen 120 flüssigen Materials, der am Polykristall hängt, wie in Figur 3a zu sehen ist. Hier und in den folgenden Figuren ist flüssiges Material schraffiert dargestellt, während festes Material weiß bzw. ohne Schraffur dargestellt ist.

In einer zweiten Phase P₂ wird nun der Impfling 140 an das untere Ende des Polykristalls 100 und damit an den Tropfen 120 flüssigen Materials, angebracht, wie in Figur 3b zu sehen, und beginnend von einem oberen Ende des Impflings 140 aufgeschmolzen. Hierzu wird der Impfling zunächst beispielsweise mit einer bestimmten Geschwindigkeit auf den Polykristall 100 zu, also nach oben, bewegt, während sich der Polykristall 100 in Ruhe befinden kann. Das Aufschmelzen des Impflings 140 beginnt dabei in der Regel erst, nachdem sich die Temperatur des Impflings 140 an diejenige des bereits flüssigen Materials angeglichen hat.

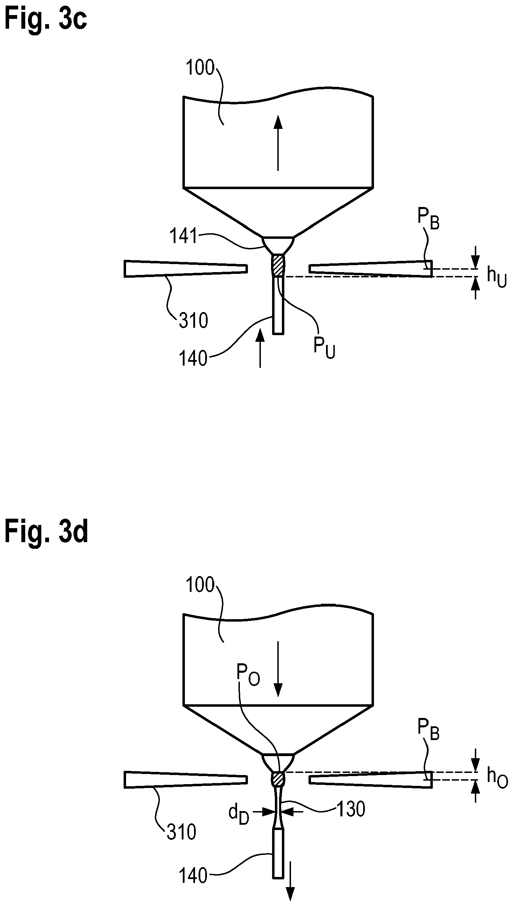

Nachdem nun der Impfling 140 an dem Tropfen flüssigen Materials am unteren Ende des Polykristalls 100 angebracht und damit verschmolzen ist, werden der Polykristall 100 und der Impfling 140 gemeinsam nach oben bewegt, wie in Figur 3c zu sehen. Dabei wird auch der Vorimpfling 141 an dem unteren Ende des Polykristalls 100 gebildet. Der Impfling kann dann über einen gewissen Bereich seiner Länge, beispielsweise zwischen 5 und 20 mm, aufgeschmolzen werden, indem der Impfling in Richtung des Lochs des Induktors 310 bewegt wird.

Es versteht sich jedoch, dass ein gewisser Bereich an dem unteren Ende des Impflings 140 nicht aufgeschmolzen wird, da dieser Abschnitt zur Befestigung in einer Ziehvorrichtung (als Teil der erwähnten Anlage) benötigt wird.

Die Leistung der Schmelzvorrichtung 300 wird hier während der zweiten Phase P₂ in Abhängigkeit von einer Position einer unteren Phasengrenze P_{U} dynamisch angepasst. Die untere Phasengrenze P_{U} ist dabei, wie in den Figuren 3b und 3c zu sehen ist, als Phasengrenze wischen flüssigem Material und festem Material auf Seiten des Impflings 140 festgelegt.

Insbesondere kann hier nun die Position der unteren Phasengrenze P_{U} relativ zu einem fixen Bezugspunkt ermittelt werden, um eine Veränderung der unteren Phasengrenze P_{U} einfacher zu erfassen. In Figur 3c ist beispielhaft der Punkt P_{B} auf dem Induktor 310 als fixer Bezugspunkt gewählt. Sowohl die untere Phasengrenze P_{U} als auch der Bezugspunkt P_{B} können hierzu mittels der Kamera 352, wie sie in Figur 1 gezeigt ist, erfasst werden. Daraus lässt sich dann ein (unterer) Abstand h_{U} ermitteln. Es versteht sich, dass auch ein anderer Bezugspunkt verwendet werden kann, wobei dabei darauf geachtet werden sollte, dass dieser dann ebenfalls entsprechend erfasst werden kann.

Dieser (untere) Abstand h_{U} kann dann als Regelgröße verwendet werden, während die Leistung der Schmelzvorrichtung 300 entsprechend als Stellgröße verwendet wird. Wie anhand der Figur 3c zu sehen ist, kann während der zweiten Phase P₂ die untere Phasengrenze gut erfasst werden.

In einer dritten Phase P₃ wird nun zwischen einem unteren Abschnitt des Impflings 140 und dem Polykristall 100 (also dem noch festen und noch nicht geschmolzenen Anteil des Polykristalls) ein Dünnhals-Abschnitt 130 gebildet, dessen Durchmesser d_{D} mit beispielsweise 2 bis 4 mm geringer als derjenige des Impflings 140 ist. Hierzu werden der Polykristall 100 und der Impfling 140 zunächst zugleich, d.h. mit gleicher Geschwindigkeit, nach unten bewegt.

Die Absenkgeschwindigkeit des Impflings 140 wird nun zu einem gewissen Zeitpunkt gegenüber derjenigen des Polykristalls 100 erhöht. Damit nimmt der Durchmesser der Zone flüssigen Materials bzw. des dann auskristallisierenden Materials aufgrund der Massenerhaltung ab. In Figur 3d ist beispielsweise bereits ein Dünnhals-Abschnitt 130 mit einer gewissen Länge gebildet.

Bei der Ausbildung des Dünnhals-Abschnitts 130 ergibt sich nun das Problem, dass elektromagnetische Energie, die mittels der Schmelzvorrichtung 300 in das feste bzw. flüssige Material eingekoppelt werden soll, unterhalb einer Materialstärke von ca. 4 mm nur noch schwierig in das Material einkoppelt.

In Figur 5 ist hierzu ein Diagramm zur Einkopplung elektromagnetischer Energie in Halbleitermaterial dargestellt. Dabei ist ein Anteil der eingekoppelten Energie E an der gesamten, bereitgestellten Energie Eₘₐₓ über dem Durchmesser d des Halbleitermaterials in mm aufgetragen. An dem Verlauf der Kurve ist deutlich zu sehen, dass bereits ab 5 mm, insbesondere jedoch ab 4 mm, der Anteil eingekoppelter Energie immer geringer wird.

Sobald daher ein gewisser Durchmesser des Materials unterschritten wird, reduziert sich - bei Annahme einer vorgegebenen Leistung der Schmelzvorrichtung - die in das feste Material eingekoppelte Energie. Dies wiederum führt zu einer schnelleren Kristallisation mit einer damit verbundenen Änderung der Höhe bzw. des Abstands der Phasengrenze vom Induktor, damit zu einer Änderung des Durchmessers und somit erneut zu einer Änderung der eingekoppelten Energie.

Daneben hängt die Menge der eingekoppelten Energie bzw. Leistung in der Regel auch von weiteren Parametern wie dem initialen Abmessungen des Impflings 140 und des Polykristalls 100 sowie den Abmessungen und der Ausrichtung der Schmelzvorrichtung 300 bzw. des Induktors 310 ab. Bei Vorgabe eines bestimmten Werts oder eines bestimmten Verlaufs für die Leistung der Schmelzvorrichtung ist eine Ausbildung eines gewünschten Dünnhals-Abschnitts in dieser Situation also kaum möglich.

Während in der zweiten Phase die untere Phasengrenze P_{U} bzw. deren Position noch ein guter Anhaltspunkt zur Ermittlung der Leistung der Schmelzvorrichtung 300 ist, ist dies in der dritten Phase, insbesondere sobald der Dünnhals-Abschnitt 130 vorhanden ist, nicht mehr der Fall. Aufgrund der schlechten Einkopplung elektromagnetischer Energie ändert sich auch die Kristallisationsrate stark und damit schwankt die Position der untere Phasengrenze sehr stark. Dieser Effekt würde sich umso mehr erhöhen, je länger die Position der unteren Phasengrenze P_{U} zur Anpassung der Leistung der Schmelzvorrichtung 300 verwendet würde.

In der dritten Phase wird daher die obere Phasengrenze P_{O}, wie sie in den Figuren 3b und 3d gezeigt ist, bzw. deren Position zur Ermittlung der Leistung verwendet. Auch hier kann wiederum ein Abstand, hier ein (oberer) Abstand h_{O}, zu dem Bezugspunkt P_{B} (oder auch einem anderen Bezugspunkt) verwendet werden.

Sowohl die obere Phasengrenze P_{O} als auch der Bezugspunkt P_{B} können hierzu mittels der Kamera 351, wie sie in Figur 1 gezeigt ist, erfasst werden. Daraus lässt sich dann der (obere) Abstand h_{O} ermitteln. Es versteht sich, dass auch ein anderer Bezugspunkt verwendet werden kann, wobei dabei darauf geachtet werden sollte, dass dieser dann ebenfalls entsprechend erfasst werden kann.

Ein Wechsel der zur Regelung verwendeten Position bzw. Phasengrenze kann dabei vorzugsweise vor Erhöhung der Absenkgeschwindigkeit des Impflings 140 gegenüber derjenigen des Polykristalls 100 erfolgen.

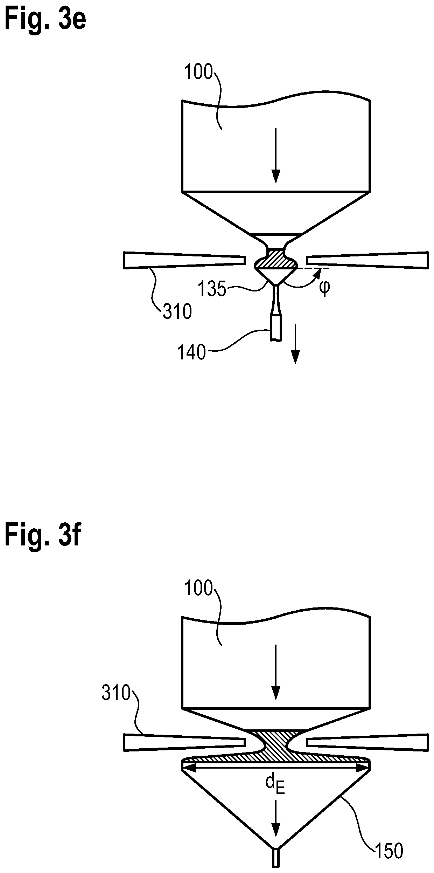

In einer vierten Phase P₄ kann nun zwischen dem Dünnhals-Abschnitt und dem Polykristall 100 ein konischer Abschnitt 135 gebildet werden, wie in Figur 3e zu sehen ist. Ein solcher konischer Abschnitt 135 dient dazu, den Durchmesser von demjenigen des Dünnhals-Abschnitts auf einen gewünschten Durchmesser d_{E} von beispielsweise 200 mm des zu fertigenden Einkristalls 150 zu weiten, wie in Figur 3f zu sehen ist.

Die Leistung der Schmelzvorrichtung 300 kann während der vierten Phase P₄ in Abhängigkeit von einem Neigungswinkel ϕ des konischen Abschnitts 135 dynamisch angepasst werden. Anstatt des Neigungswinkels ϕ könnte hier auch ein Neigungswinkel am Tripelpunkt zwischen festem Material, flüssigem Material und Umgebung verwendet werden. Denkbar sind jedoch auch geeignete andere Größen, wie bereits erwähnt wurde.

Damit kann eine gewünschte Form des Konus, also insbesondere ein gewünschter Neigungswinkel erreicht werden. Der Neigungswinkel kann beispielsweise ebenfalls mit der Kamera 352 erfasst werden. Nachdem der gewünschte Durchmesser d_{E} des Einkristalls 150 erreicht ist, kann die Regelung der Leistung auf übliche Verfahren umgestellt werden.

## Patentansprüche

1. Verfahren zum Ziehen eines Einkristalls (150) nach dem FZ-Verfahren, bei dem ein Polykristall (100) mittels einer elektromagnetischen Schmelzvorrichtung (300) aufgeschmolzen und anschließend wieder auskristallisiert wird,
wobei in einer ersten Phase (P₁) ein unteres Ende des Polykristalls (100) mittels der Schmelzvorrichtung (300) aufgeschmolzen wird,
wobei in einer zweiten Phase (P₂) ein einkristalliner Impfling (140) an das untere Ende des Polykristalls (100) angebracht, und
wobei in einer dritten Phase (P₃) zwischen einem unteren Abschnitt des Impflings (140) und dem Polykristall (100) ein Dünnhals-Abschnitt (130) gebildet wird, dessen Durchmesser (d_{D}) geringer als derjenige (d_{I}) des Impflings (140) ist,
**dadurch gekennzeichnet, dass** eine Leistung der Schmelzvorrichtung (300) vor der dritten Phase (P₃) wenigstens zeitweise in Abhängigkeit von einer Position einer unteren Phasengrenze (P_{U}) zwischen flüssigem Material und festem Material auf Seiten des Impflings (140) dynamisch angepasst wird, und
dass die Leistung der Schmelzvorrichtung während der dritten Phase (P₃) wenigstens zeitweise in Abhängigkeit von einer Position einer oberen Phasengrenze (Po) zwischen flüssigem Material und festem Material auf Seiten des Polykristalls (100) dynamisch angepasst wird, und ein Wechsel der Abhängigkeit von der Position der unteren Phasengrenze (P_{U}) unmittelbar zu der Abhängigkeit von der Position der oberen Phasengrenze (P_{O}) vorgenommen wird.

2. Verfahren nach Anspruch 1, wobei ein Wechsel der Abhängigkeit von der Position der unteren Phasengrenze (P_{U}) zu der Abhängigkeit von der Position der oberen Phasengrenze (P_{O}) vor einer Erhöhung einer Geschwindigkeit, mit welcher der Impfling (140) und/oder der Polykristall (100) in vertikaler Richtung bewegt werden, erfolgt.

3. Verfahren nach einem der vorstehenden Ansprüche, wobei in einer vierten Phase (P₄) zwischen dem Dünnhals-Abschnitt (130) und dem Polykristall (100) ein konischer Abschnitt (135) gebildet wird, und
wobei die Leistung der Schmelzvorrichtung (300) während der vierten Phase (P₄) wenigstens zeitweise in Abhängigkeit von einer charakteristischen Größe, mit der auf einen Neigungswinkel (ϕ) des konischen Abschnitts (135) geschlossen werden kann, dynamisch angepasst wird.

4. Verfahren nach Anspruch 3, wobei als die charakteristische Größe der Neigungswinkel des konischen Abschnitts von kristallisiertem Material, ein Neigungswinkel des konischen Abschnitts an einem Tripelpunkt zwischen festem Material, flüssigem Material und Umgebung, eine Änderung eines Durchmessers des konischen Abschnitts (135) oder der Durchmesser des konischen Abschnitts (135) an der unteren Phasengrenze verwendet wird.

5. Verfahren nach Anspruch 3 oder 4, wobei bei der Anpassung der Leistung der Schmelzvorrichtung (300) ein Wechsel der Abhängigkeit von der Position der oberen Phasengrenze (P_{O}) unmittelbar zu der Abhängigkeit von der charakteristischen Größe vorgenommen wird, oder
wobei die Leistung der Schmelzvorrichtung (300) zeitweise zeitgleich in Abhängigkeit von der Position der oberen Phasengrenze (P_{O}) und in Abhängigkeit von der charakteristischen Größe angepasst wird.

6. Verfahren nach einem der Ansprüche 3 bis 5, wobei der Wechsel der Abhängigkeit von der Position der oberen Phasengrenze (P_{O}) zu der Abhängigkeit von der charakteristischen Größe erfolgt, sobald eine Erkennung der Position der oberen Phasengrenze (P_{O}) nur noch mit weniger als einer vorbestimmten Genauigkeit möglich ist.

7. Verfahren nach einem der Ansprüche 3 bis 6, wobei die für den Neigungswinkel (ϕ) des konischen Abschnitts charakteristische Größe unter Verwendung einer Kamera (352), die insbesondere unterhalb der Schmelzvorrichtung (300) angeordnet ist, ermittelt wird.

8. Verfahren nach einem der vorstehenden Ansprüche, wobei die Position der unteren Phasengrenze (P_{U}) und/oder der oberen Phasengrenze (P_{O}) jeweils als Abstand (h_{U}, h_{O}) der jeweiligen Phasengrenze zu einem fixen Bezugspunkt (P_{B}), insbesondere an der Schmelzvorrichtung (300), berücksichtigt werden.

9. Verfahren nach einem der vorstehenden Ansprüche, wobei die Position der unteren Phasengrenze (P_{U}) unter Verwendung einer Kamera (352), die insbesondere unterhalb der Schmelzvorrichtung (300) angeordnet ist, berücksichtigt wird.

10. Verfahren nach einem der vorstehenden Ansprüche, wobei die Position der oberen Phasengrenze (P_{O}) unter Verwendung einer Kamera (351), die insbesondere oberhalb der Schmelzvorrichtung (300) angeordnet ist, berücksichtigt wird.

## Claims

1. Method for pulling a single crystal (150) according to the FZ method, in which a polycrystal (100) is melted by means of an electromagnetic melting device (300) and subsequently recrystallized,
wherein in a first phase (P₁) a lower end of the polycrystal (100) is melted by means of the melting device (300),
wherein, in a second phase (P₂), a single-crystal seed ring (140) is attached to the lower end of the polycrystal (100), and
wherein, in a third phase (P₃), a thin-neck portion (130) is formed between a lower portion of the seedling (140) and the polycrystal (100), the diameter (d_{D}) of which is smaller than that (d_{I}) of the seedling (140),
**characterized in that** a power of the melting device (300) before the third phase (P₃) is dynamically adjusted at least temporarily as a function of a position of a lower phase boundary (P_{U}) between liquid material and solid material on the side of the inoculation (140), and
**in that** the power of the melting device is dynamically adapted during the third phase (P₃) at least temporarily as a function of a position of an upper phase boundary (P_{O}) between liquid material and solid material on the side of the polycrystal (100), and a change of the dependence from the position of the lower phase boundary (P_{U}) is made directly to the dependence from the position of the upper phase boundary (P_{O}).

2. Method according to claim 1, wherein a change of the dependence from the position of the lower phase boundary (P_{U}) to the dependence from the position of the upper phase boundary (P_{O}) takes place before an increase of a speed with which the seed (140) and/or the polycrystal (100) are moved in vertical direction.

3. Method according to one of the above claims, wherein in a fourth phase (P₄) a conical portion (135) is formed between the thin neck portion (130) and the polycrystal (100), and
wherein the power of the melting device (300) is dynamically adapted during the fourth phase (P₄) at least temporarily as a function of a characteristic variable with which an angle of inclination (ϕ) of the conical section (135) can be inferred.

4. Method according to claim 3, wherein as the characteristic quantity the angle of inclination of the conical portion of crystallized material, an angle of inclination of the conical portion at a triple point between solid material, liquid material and the environment, a change in a diameter of the conical portion (135) or the diameter of the conical portion (135) at the lower phase boundary is used.

5. Method according to claim 3 or 4, wherein, when the power of the melting device (300) is adjusted, a change in the dependence from the position of the upper phase boundary (P_{O}) is made directly to the dependence on the characteristic variable, or
wherein the power of the melting device (300) is temporarily adjusted simultaneously as a function of the position of the upper phase boundary (P_{O}) and as a function of the characteristic quantity.

6. Method according to one of claims 3 to 5, wherein the change of the dependence from the position of the upper phase boundary (P_{O}) to the dependence on the characteristic quantity takes place as soon as a detection of the position of the upper phase boundary (P_{O}) is only possible with less than a predetermined accuracy.

7. Method according to one of claims 3 to 6, wherein the characteristic value for the angle of inclination (ϕ) of the conical section is determined using a camera (352) which is arranged in particular below the melting device (300).

8. Method according to one of the above claims, wherein the position of the lower phase boundary (P_{U}) and/or the upper phase boundary (P_{O}) are each taken into account as the distance (h_{U}, h_{O}) of the respective phase boundary from a fixed reference point (P_{B}), in particular at the melting device (300).

9. Method according to one of the above claims, taking into account the position of the lower phase boundary (P_{U}) by using a camera (352) which is arranged in particular below the melting device (300).

10. Method according to one of the above claims, wherein the position of the upper phase boundary (P_{O}) is taken into account by using a camera (351) which is arranged in particular above the melting device (300).

## Revendications

1. Procédé de tirage d'un monocristal (150) selon la méthode FZ, dans laquelle un polycristal (100) est fondu au moyen d'un dispositif de fusion électromagnétique (300) et ensuite recristallisé,
dans laquelle, dans une première phase (P₁), une extrémité inférieure du polycristal (100) est fondue au moyen du dispositif de fusion (300),
dans laquelle, dans une deuxième phase (P₂), un anneau d'ensemencement monocristallin (140) est fixé à l'extrémité inférieure du polycristal (100), et
dans laquelle, dans une troisième phase (P₃), une partie à col mince (130) est formée entre une partie inférieure du plant (140) et le polycristal (100), dont le diamètre (d_{D}) est inférieur à celui (d_{I}) du plant (140),
**caractérisé en ce qu'**une puissance du dispositif de fusion (300) avant la troisième phase (P₃) est dynamiquement ajustée au moins temporairement en fonction d'une position d'une limite de phase inférieure (Pu) entre la matière liquide et la matière solide du côté de l'inoculation (140), et
**en ce que** la puissance du dispositif de fusion est adaptée dynamiquement pendant la troisième phase (P₃) au moins temporairement en fonction d'une position d'une limite de phase supérieure (P_{O}) entre le matériau liquide et le matériau solide du côté du polycristal (100), et une modification de la dépendance de la position de la limite de phase inférieure (P_{U}) est effectuée directement à la dépendance de la position de la limite de phase supérieure (P_{O}).

2. Procédé selon la revendication 1, dans lequel un changement de la dépendance de la position de la limite de phase inférieure (P_{U}) à la dépendance de la position de la limite de phase supérieure (P_{O}) a lieu avant une augmentation de la vitesse avec laquelle la graine (140) et/ou le polycristal (100) sont déplacés dans la direction verticale.

3. Procédé selon l'une des revendications ci-dessus, dans lequel, dans une quatrième phase (P₄), une partie conique (135) est formée entre la partie de col mince (130) et le polycristal (100), et
dans lequel la puissance du dispositif de fusion (300) est adaptée dynamiquement pendant la quatrième phase (P₄) au moins temporairement en fonction d'une variable caractéristique avec laquelle un angle d'inclinaison (ϕ) de la section conique (135) peut être déduit.

4. Procédé selon la revendication 3, dans lequel on utilise comme grandeur caractéristique l'angle d'inclinaison de la partie conique du matériau cristallisé, un angle d'inclinaison de la partie conique en un point triple entre le matériau solide, le matériau liquide et l'environnement, une modification d'un diamètre de la partie conique (135) ou du diamètre de la partie conique (135) à la limite de phase inférieure.

5. Procédé selon la revendication 3 ou 4, dans lequel, lors du réglage de la puissance du dispositif de fusion (300), une modification de la dépendance de la position de la limite supérieure de phase (P_{O}) est directement effectuée à la dépendance de la grandeur caractéristique, ou
dans lequel la puissance du dispositif de fusion (300) est temporairement ajustée simultanément en fonction de la position de la limite supérieure de phase (P_{O}) et en fonction de la quantité caractéristique.

6. Procédé selon l'une des revendications 3 à 5, dans laquelle le changement de la dépendance de la position de la limite supérieure de phase (P_{O}) à la dépendance de la grandeur caractéristique a lieu dès qu'une détection de la position de la limite supérieure de phase (P_{O}) n'est possible qu'avec une précision inférieure à une précision prédéterminée.

7. Procédé selon l'une des revendications 3 à 6, dans lequel la valeur caractéristique de l'angle d'inclinaison (ϕ) de la section conique est déterminée à l'aide d'une caméra (352) qui est disposée en particulier sous le dispositif de fusion (300).

8. Procédé selon l'une des revendications ci-dessus, dans laquelle la position de la limite de phase inférieure (P_{U}) et/ou de la limite de phase supérieure (P_{O}) sont chacune prises en compte comme distance (h_{U}, h_{O}) de la limite de phase respective par rapport à un point de référence fixe (P_{B}), en particulier au niveau du dispositif de fusion (300).

9. Procédé selon l'une des revendications ci-dessus, prenant en compte la position de la limite inférieure de phase (P_{U}) en utilisant une caméra (352) qui est disposée en particulier sous le dispositif de fusion (300).

10. Procédé selon l'une des revendications ci-dessus, dans laquelle la position de la limite supérieure de phase (P_{O}) est prise en compte en utilisant une caméra (351) qui est disposée en particulier au-dessus du dispositif de fusion (300).
